# FASCICULE DE BREVET EUROPEEN

(11) **EP 3 671 871 B1**
(45) Date de publication et mention de la délivrance du brevet: **16.06.2021**
(21) Numéro de dépôt: 19216374.9
(22) Date de dépôt: 16.12.2019
(51) Int. Cl.: H01L 37/02

(54) **PROCEDE DE FABRICATION D'UN DISPOSITIF COMPRENANT UN MATERIAU ACQUERANT UNE PROPRIETE ELECTRIQUE APRES AVOIR ETE SOUMIS A UNE POLARISATION ELECTRIQUE**
HERSTELLUNGSVERFAHREN EINER VORRICHTUNG, DIE EIN MATERIAL UMFASST, DAS NACH EINER ELEKTRISCHEN POLARISIERUNG ELEKTRISCHE EIGENSCHAFTEN ERWIRBT
METHOD FOR MANUFACTURING A DEVICE COMPRISING A MATERIAL ACQUIRING ELECTRICAL PROPERTIES AFTER BEING SUBJECTED TO ELECTRICAL POLARISATION

(30) Priorité: 18.12.2018 FR 1873250
(43) Date de publication de la demande: 24.06.2020
(73) Titulaire: Commissariat à l'énergie atomique et aux énergies alternatives, 75015 Paris (FR)
(72) Inventeur: MAINGUET, Jean-François, 38054 GRENOBLE CEDEX 09 (FR); REVAUX, Amélie, 38054 GRENOBLE CEDEX 09 (FR)
(74) Mandataire: Brevalex

(56) Documents cités:
- EP-A- 0 326 973
- EP-A- 0 371 868
- EP-A1- 1 178 545

## Description

### DOMAINE TECHNIQUE ET ÉTAT DE LA TECHNIQUE ANTÉRIEURE

La présente invention se rapporte à un procédé de fabrication d'un dispositif comprenant au moins une couche de matériau acquérant une propriété électrique après avoir été soumis à une polarisation, par exemple comprenant un matériau devenant pyroélectrique par polarisation.

Par exemple dans le domaine des capteurs d'empreintes, et plus généralement des capteurs de motifs thermiques on utilise l'effet pyroélectrique, i.e. la génération de charges du fait d'une variation de température.

Un capteur d'empreintes thermique comporte une matrice de pixels, chacun apte à générer des charges par variation de température. Chaque pixel comporte un matériau pyroélectrique entre deux électrodes, chaque pixel est adressable individuellement pour permette de détecter la quantité de charge produite par chacun des pixels. Une empreinte digitale comporte des crêtes et des vallées et le contact entre un pixel et une crête ou une vallée provoque une variation de température, qui est différente selon qu'il s'agit d'une crête ou d'une vallée. De préférence, les pixels sont chauffés afin d'éviter un équilibre thermique entre le capteur et la surface du doigt

Le PVDF (poly(fluorure de vinylidène)) et ses divers copolymères comme le PVDF-TrFE (tri fluoro éthylène) présentent des propriétés pyroélectriques, ces propriétés apparaissent après application d'une certaine tension de polarisation.

Par ailleurs, afin de piloter chacun des pixels ou groupe de pixels un ou plusieurs transistors peuvent être mis en œuvre.

Par exemple, au moins trois transistors peuvent être mis en œuvre au niveau de chaque pixel pour lire la tension : un transistor assurant l'amplification du signal, un deuxième transistor permettant la sélection du pixel et un troisième transistor permettant de mettre la tension à une valeur connue en début d'acquisition.

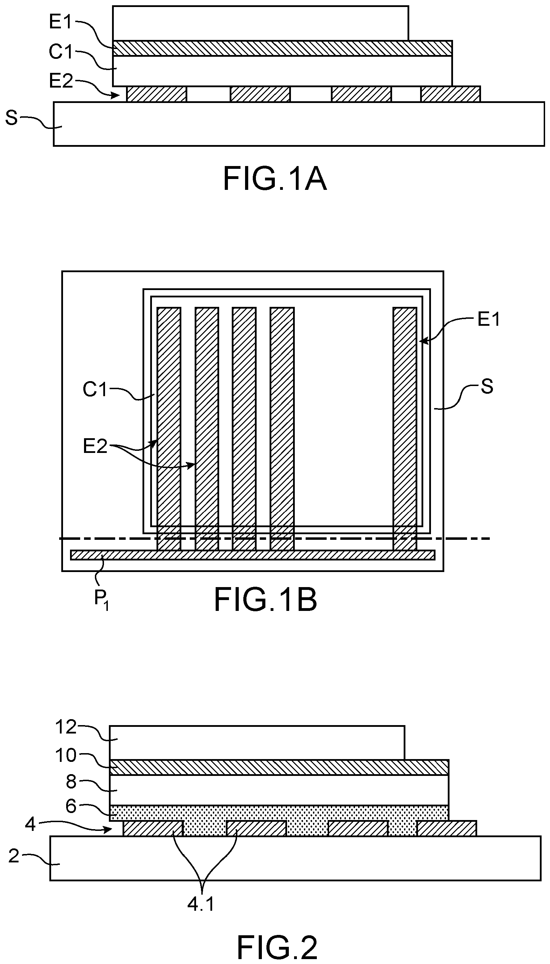

Sur la figure 1A, on peut voir un dispositif de l'état de la technique comportant un substrat S, une couche de PVDF C1 entre une couche conductrice métallique formant électrode commune E1 et une pluralité de bandes parallèles conductrices électriques formant des électrodes individuelles E2. Dans un autre exemple, le dispositif comporte une couche de PVDF entre une couche conductrice métallique formant électrode commune et une pluralité de zones conductrices au niveau de chaque pixel.

Comme indiqué ci-dessus, le PVDF devient pyroélectrique après avoir été polarisé. La tension à appliquer pour polariser le PVDF est comprise entre 75 V et 150 V par µm d'épaisseur de PVDF. Cette polarisation est réalisée entre l'électrode commune et les électrodes individuelles. En outre, si cette polarisation est à réaliser alors que des transistors de pilotage sont déjà en place, ce niveau de tension peut provoquer un endommagement, voire une destruction des transistors.

Afin d'éviter d'avoir à connecter individuellement chaque pixel ou groupe de pixels à une source de polarisation, préalablement à l'étape de polarisation, toutes les électrodes individuelles E2 sont mises en court-circuit, par exemple en prévoyant une piste électrique P1 reliant toutes les électrodes individuelles comme cela est représenté sur la figure 1B, ce qui permet d'appliquer plus simplement une tension de polarisation à travers la couche de PVDF. Cependant cette mise en court-circuit doit être supprimée afin de rendre le dispositif utilisable, pour cela la piste électrique est supprimée après la polarisation. Cette piste électrique P1 est supprimée par découpage du substrat (le long de la ligne en pointillés sur la figure 1B), il en résulte une perte de matière et de place disponible. En outre il peut en résulter des copeaux et ou des débris qui peuvent perturber le bon fonctionnement du dispositif. De plus il existe un risque que la découpe ne soit pas réussie et que le dispositif soit inutilisable.

Dans le cas d'un dispositif présentant par exemple un transistor de sélection par pixel dans lequel la source est connectée à l'électrode individuelle E2 du pixel, le drain est relié à une colonne et la grille est connectée à une ligne électrique de sélection, afin d'éviter la destruction du transistor, il faut rendre tous les transistors du plan pixel conducteurs en appliquant une tension de grille adaptée, et donc en reliant momentanément toutes les grilles, ainsi que toutes les colonnes, ce qui rend le procédé complexe. Une exemple de l'etat technique antérieure est décrit dans le brevet EP0371868, qui divulgue une structure qui comprend une couche de polyimide isolant électrique et thermique, des senseurs à infrarouge isolés les uns des autres comportant un film pyroélectrique de polyvinyle dont la face au contact du polyimide est équipée de deux électrodes en forme de peignes dont les dents sont imbriquées, le film pyroélectrique étant polarisé dans un plan parallèle au film et selon des directions parallèle et perpendiculaire aux dents des peignes, un circuit intégré comportant une face au contact de la couche de polyimide, équipée de circuit de lecture, des zones de contact électrique traversant de part en part la couche de polyimide et connectant les électrodes de chaque senseur à un circuit de lecture.

### EXPOSÉ DE L'INVENTION

C'est par conséquent un but de la présente invention d'offrir un procédé de fabrication d'un dispositif comportant un matériau apte à acquérir au moins une propriété électrique, ne présentant pas les inconvénients énumérés ci-dessus.

Le but précédemment énoncé est atteint avec un procédé de fabrication mettant en œuvre une couche d'un matériau apte à acquérir au moins une propriété électrique après avoir été soumis à une polarisation, une électrode commune et des électrodes individuelles de part et d'autre du matériau apte acquérir la propriété électrique, et une couche dite de polarisation en contact avec toutes les électrodes individuelles, la couche de polarisation présentant la propriété d'être conductrice électrique, et après application d'un traitement spécifique, d'être isolante électrique.

Par exemple, en utilisant une telle couche de polarisation dans un empilement comprenant une couche de poly(fluorure de vinylidène) (PVDF), il est possible de mettre simplement en court-circuit toutes les électrodes individuelles et éventuellement les transistors le cas échéant, et ainsi de pouvoir appliquer une tension suffisante pour polariser le PVDF, qui devient alors pyroélectrique. En appliquant un traitement spécifique à cette couche de polarisation, elle devient isolante électrique, ce qui supprime la mise en court-circuit des électrodes et éventuellement des transistors, rendant le dispositif fonctionnel.

En d'autres termes, le procédé de fabrication met en œuvre une couche dédiée pour polariser le matériau et lui donner sa propriété électrique, cette couche étant rendue non fonctionnelle après que le matériau ait acquis sa propriété électrique.

Par exemple, un tel matériau est une colle réticulable contenant un ou des sels d'initiation de la photopolymérisation, telle que la colle époxy LP 655 fabriquée par DELO. Les sels présents dans la formulation assurent une conduction ionique qui disparait après insolation UV, ce qui rend la colle isolante électrique lors de sa réticulation sous UV.

Dans un exemple, la couche de polarisation est disposée entre la couche de matériau à polariser et les électrodes individuelles. De manière plus avantageuse, la couche est disposée entre le substrat et les électrodes individuelles, ce qui limite les interactions entre le matériau à polariser, par exemple le PVDF et le matériau de la couche de polarisation, dont on ne connaît pas les effets à long terme.

Afin de réaliser ce court-circuit, il suffit de réaliser une couche de polarisation pleine plaque. Avantageusement, la couche de polarisation peut être localisée.

Le procédé selon l'invention présente l'avantage de ne nécessiter aucune étape de découpe ou toute autre étape susceptible de polluer le dispositif. La suppression des courts-circuits se fait de manière simple. L'application d'un rayonnement ultra-violet dans le cas de la colle LP 655 n'a pas d'effet dommageable sur le reste des composants du dispositif.

Selon une caractéristique additionnelle, on prévoit des plots de contact destinés à au moins vérifier après traitement si la couche de polarisation est effectivement devenue isolante électrique.

Le procédé selon l'invention est avantageusement mis en œuvre dans la fabrication de capteurs de motifs thermique, en particuliers les capteurs d'empreintes digitales.

L'invention est d'autant plus intéressante pour des dispositifs mettant en œuvre des transistors, en effet les transistors sont de plus en plus petits et de plus en plus sensibles au champ électrique. La mise en court-circuit grâce à la couche de polarisation permet de les protéger efficacement.

La présente invention a alors pour objet un procédé de fabrication d'un dispositif comportant un empilement comprenant une première couche comportant au moins deux conducteurs électriques isolés électriquement l'un de l'autre, une deuxième couche comportant au moins un conducteur électrique, au moins une troisième couche de matériau présentant au moins une propriété électrique, ladite troisième couche étant disposée entre la première couche et la deuxième couche, ledit procédé comportant :
a) une étape de réalisation, sur un substrat, d'un empilement comprenant la première couche, la deuxième couche et la troisième couche d'un matériau qui, après polarisation électrique, devient ledit matériau présentant ladite propriété électrique, la première couche et la deuxième couche étant disposées l'une par rapport à l'autre de sorte à permettre l'application d'une tension de polarisation au sein de la troisième couche,
b) une étape de réalisation d'une couche de polarisation en contact électrique avec les au moins deux conducteurs électriques de la première couche, ladite couche de polarisation comportant un matériau qui présente un premier état dans lequel il est conducteur électrique et un deuxième état dans lequel il est isolant électrique, le passage du premier état au deuxième état étant obtenu par application d'un traitement à ladite couche de polarisation, ladite couche de polarisation étant réalisée de sorte à être initialement dans son premier état,
c) une étape d'application d'une tension de polarisation à ladite troisième couche de sorte que son matériau présente ladite propriété électrique,
d) une étape d'application dudit traitement transformant au moins une partie du matériau de la couche de polarisation dans son deuxième état, de sorte que lesdits au moins deux conducteurs électriques de la première couche sont isolés électriquement les uns des autres.

Par exemple, le matériau de la troisième couche devient pyroélectrique en appliquant une polarisation donnée.

Selon un exemple de réalisation, la couche de polarisation est formée entre la première couche et la troisième couche. Selon un autre exemple de réalisation, la couche de polarisation est formée entre le substrat et la première couche.

Selon une caractéristique additionnelle, les conducteurs de la première couche sont réalisés en forme de bandes et la couche de polarisation est formée de sorte à être en contact avec une partie au moins de chacune des bandes. Dans un exemple avantageux, la couche de polarisation peut être formée de sorte à être en contact avec une extrémité longitudinale des bandes.

Selon une caractéristique additionnelle, le procédé comporte l'étape de réalisation de deux contacts électriques en contact électrique avec la couche de polarisation, lesdits contacts électriques étant destinés à au moins vérifier la conductivité électrique de ladite couche de polarisation au moins après le traitement.

Le procédé de fabrication comporte avantageusement l'étape de réalisation d'au moins deux transistors, chaque transistor étant connecté à un conducteur électrique, la couche de polarisation étant formée de sorte à être connectée électriquement au moins aux drains des transistors, et lors de l'étape c) la couche de polarisation, les drains, les sources et les grilles sont en court-circuit.

Dans un exemple particulièrement avantageux, la couche de polarisation est une colle réticulable contenant un ou plusieurs sels d'initiation de réticulation, et le traitement est une insolation au rayonnement ultraviolet. Le matériau de la troisième couche peut comporter du poly(fluorure de vinylidène) ou l'un de ses dérivés.

Dans un exemple de réalisation, le substrat est en un matériau transparent au rayonnement ultraviolet et l'insolation est réalisée à travers le substrat.

Il peut être envisagées que, lors de l'étape d), seules des portions de la couche de polarisation situées entre les conducteurs sont rendues isolantes électriques.

Selon une caractéristique additionnelle, l'insolation se fait à travers un masque.

La présente invention a également pour objet un procédé de fabrication d'un capteur de motifs thermiques comportant la fabrication d'un dispositif comprenant un empilement par le procédé selon l'invention, l'étape de réalisation, sur ledit empilement, des lignes conductrices électriques formant une source de chaleur et l'étape de réalisation d'une couche d'encapsulation.

La présente invention a également pour objet un empilement en vue de réaliser un dispositif comportant au moins une première couche comportant au moins deux conducteurs électriques isolés électriquement l'un de l'autre, une deuxième couche comportant au moins un conducteur électrique, une troisième couche en un matériau présentant après polarisation électrique au moins une propriété électrique, ladite troisième couche étant disposée entre la première couche et la deuxième couche, ledit empilement étant obtenu en mettant en œuvre le procédé de fabrication selon l'invention, ledit empilement comportant la première couche, la deuxième couche, la troisième couche, le matériau de la troisième couche ne présentant pas ladite propriété électrique et une couche de polarisation en un matériau qui présente un premier état dans lequel il est conducteur électrique et un deuxième état dans lequel il est isolant électrique, le passage du premier état au deuxième état étant obtenu par application d'un traitement audit deuxième matériau, ladite couche de polarisation étant réalisée de sorte à être initialement dans son premier état, ladite couche de polarisation étant en contact électrique avec les conducteurs électriques de la première couche.

Par exemple, le matériau de la troisième couche est du poly(fluorure de vinylidène) ou l'un de ses dérivés, et le matériau de la couche de polarisation est une colle réticulable contenant un ou plusieurs sels d'initiation de réticulation, par exemple une colle époxy, ledit traitement étant une insolation au rayonnement ultra-violet.

### BRÈVE DESCRIPTION DES DESSINS

La présente invention sera mieux comprise sur la base de la description qui va suivre et des dessins en annexe sur lesquels :
La figure 1A est une représentation schématique en vue de côté, d'un empilement de l'état de la technique, comportant une couche de PVDF à polariser,
La figure 1B est une représentation schématique en vue de dessus, de l'empilement de la figure 1A,
La figure 2 est une représentation schématique en vue de côté, d'un empilement selon l'invention comportant une couche de PVDF à polariser,
La figure 3 est une représentation schématique de l'empilement de la figure 2 lors d'un exemple d'étape de traitement visant à rendre isolante la couche de polarisation,
La figure 4 est une représentation schématique de l'empilement de la figure 2 lors d'un autre exemple d'étape de traitement visant à rendre isolante la couche de polarisation,
La figure 5 est une représentation schématique en vue de côté, d'un autre exemple d'empilement selon l'invention comportant une couche de PVDF à polariser,
La figure 6 est une représentation schématique d'une variante de réalisation de la figure 5 mettant en œuvre des plots de contact,
La figure 7A est une représentation schématique vue de dessus d'un autre exemple de réalisation d'un empilement selon l'invention,
La figure 7B est une vue en coupe le long du plan A-A de la figure 7A,
Les figures 8A et 8B sont des représentations schématiques de deux autres exemples de réalisation d'empilements selon l'invention mettant en œuvre des transistors,
La figure 9 est une représentation schématique d'un autre exemple de réalisation d'un empilement selon l'invention mettant en œuvre des transistors,
La figure 10 est une représentation graphique de la variation du courant I en fonction de la tension U dans une couche de polarisation après différentes durées d'insolation.

### EXPOSÉ DÉTAILLÉ DE MODES DE RÉALISATION PARTICULIERS

Dans la description qui va suivre, l'invention sera décrite principalement dans le cadre de la fabrication d'un empilement comportant du PVDF afin de le rendre pyroélectrique, en vue d'une application à la réalisation de capteurs d'empreintes, et plus généralement à la réalisation de capteurs thermiques. Mais l'invention peut s'appliquer à tous les dispositifs dont la fabrication requiert une étape de polarisation pour faire acquérir à un matériau une propriété électrique, dont des exemples seront donnés ci-dessous.

Dans la description qui va suivre, un matériau isolant ou conducteur est un matériau isolant électrique ou conducteur électrique respectivement, à moins que cela soit précisé explicitement.

Le procédé de fabrication selon l'invention comporte les étapes générales suivantes :
- réalisation d'un empilement comportant un matériau apte à acquérir au moins une propriété électrique et disposé entre une électrode commune et au moins deux électrodes individuelles,
- réalisation d'une couche de polarisation mettant en court-circuit les électrodes individuelles et éventuellement les transistors. La couche de polarisation est par exemple réalisée par un procédé d'impression ou d'enduction choisi en fonction de la viscosité du matériau de la couche. La couche de polarisation est réalisée par exemple par enduction au rouleau, enduction à fente (slot-die en anglais) ou par sérigraphie,
- application d'une polarisation à la couche apte à acquérir la propriété électrique en utilisant la couche de polarisation,
- application d'un traitement pour rendre la couche de polarisation isolante électrique.

Dans la présente demande, on entend par « propriété électrique » d'un matériau, une propriété par laquelle le matériau est capable de générer une tension ou un courant, par exemple lorsqu'il est soumis à un variation de température, il s'agit de la pyroélectricité, ou lorsqu'il est soumis à une déformation, il s'agit de la piézoélectricité, ou lorsqu'il est le siège de polarisation permanente après avoir été soumis à une polarisation, tels que les électrets. Sur la figure 2, on peut voir un exemple d'empilement EP1 obtenu en mettant en œuvre un exemple de procédé de polarisation selon l'invention. Cet empilement peut être utilisé pour réaliser un capteur d'empreinte.

L'empilement EP1 comporte dans cet ordre un substrat 2, une couche 4 comportant une pluralité de bandes 4.1 conductrices électriques parallèles destinées à former des électrodes individuelles. L'empilement EP1 comporte une couche de polarisation 6, une couche 8 de matériau apte à avoir des propriétés pyroélectriques sous l'effet d'une polarisation, une couche conductrice électrique 10 destinée à former une électrode commune au droit des électrodes individuelles. Dans l'exemple représenté, une couche 12 destinée à protéger l'empilement est formée sur la couche 10.

Le matériau pyroélectrique de la couche 8 peut être par exemple un polyfluorure de vinylidène ou PVDF, un polyfluorure de vinylidène-trifluoroéthylène ou P(VDF-TrFE), une céramique telle que du PZT (titano-zirconate de plomb, ou « Lead Zirconate Titanate » en anglais), des cristaux tels que ceux connus sous l'acronyme TGS (Tris Glycine SDF) ou des cristaux LiTaO₃.

L'électrode commune 10 est reliée à une tension donnée, par exemple à la masse.

Le substrat est par exemple isolant électrique, par exemple en un matériau rigide tel que le verre, ou un matériau souple, tel que le matériau plastique comme le polyéthylène (PET), le poly(naphtalate d'éthylène) (PEN), le polyuréthane (PU) ou le polydiméthyl(siloxane) (PDMS).

En variante, le dispositif peut être fabriqué à partir d'une technologie CMOS sur substrat silicium ou sur substrat silicium sur isolant SOI (Silicon on Insulator).

Dans la présente demande, on entend par « électrode individuelle » une électrode destinée à former avec l'électrode commune une partie au plus des pixels. Dans l'exemple de la figure 1B, chaque électrode individuelle forme un pixel de type colonne avec le PVDF et l'électrode commune. Dans d'autres exemples des lignes de chauffage perpendiculaires aux électrodes individuelles sont formées, le croisement d'une ligne de chauffage et d'une électrode individuelle étant considéré comme un pixel.

La couche de polarisation 6 comporte un matériau qui offre un état dans lequel il est conducteur électrique et un état, après application d'un traitement donné, dans lequel il est isolant électrique.

Dans la présente demande, on entend par « conducteur électrique » un matériau suffisamment conducteur pour assurer une mise en court-circuit des électrodes et/ou des transistors, et permettre l'application d'une tension de polarisation suffisante pour rendre le matériau de la couche 8 pyroélectrique en quelques secondes jusqu'à 1 min. Un matériau même très faiblement conducteur électrique peut convenir.

On entend par « matériau isolant électrique », un matériau suffisamment isolant pour que la quantité de charges produite au niveau d'un pixel puisse être détectée séparément de celles générées au niveau des autres pixels. Par exemple on cherche à avoir une circulation de courant dans la couche de polarisation après traitement d'environ au moins 100 fois inférieure à la circulation dans les électrodes individuelles.

Le matériau de la couche de polarisation 6 est une colle réticulable contenant un ou plusieurs sels d'initiation de réticulation, par exemple une colle époxy. Par exemple des photoamorceurs cationiques tels que les sels de diaryliodonium ou de triarylsulfonium sont des sels d'initiation de réticulation adaptés à la présente invention.

Le sel d'initiation est conducteur ionique, ce qui rend le matériau faiblement conducteur électrique avant réticulation. Après réticulation, le matériau devient isolant électrique. La colle époxy produite par la société DELO est par exemple une colle dont les sels ajoutés dans la formulation sont des sels initiateurs de photopolymérisation sous UV.

Par exemple, la couche de polarisation comporte de la colle époxy LP655 fabriquée par DELO qui passe d'un état conducteur à un état isolant électrique par réticulation sous insolation au rayonnement ultraviolet (UV) à une longueur d'onde de l'ordre de 365 nm.

La couche de polarisation 6 a par exemple une épaisseur d'une centaine de nm à quelques µm.

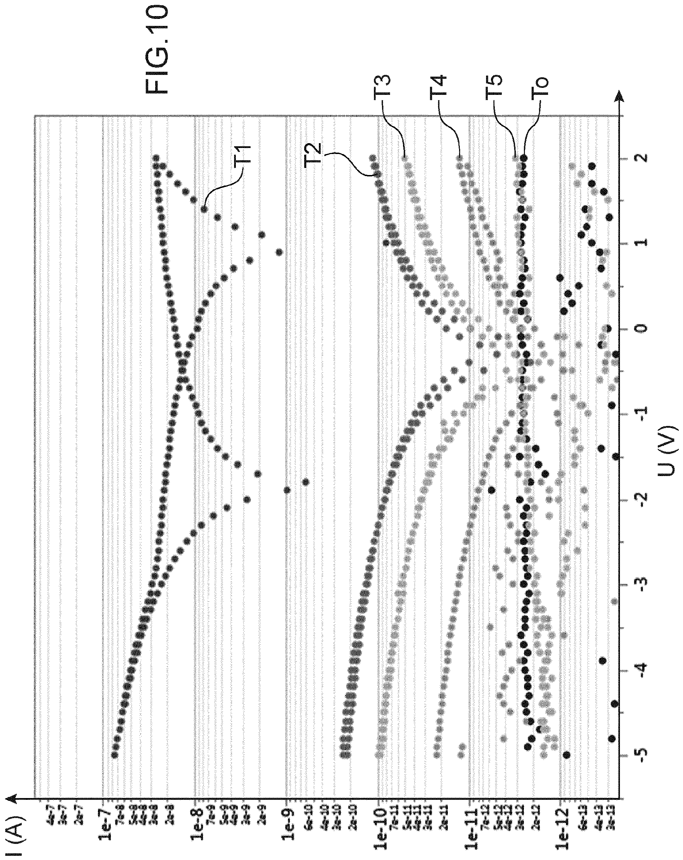

La figure 10 illustre l'évolution de la conductivité électrique en fonction du niveau de réticulation de la colle LP655. Elle représente la variation du courant I en Ampère entre deux barreaux conducteurs électriques connectés par une goutte de colle LP655 en fonction de la tension U en Volt.

Chaque courbe représente une conductivité électrique pour un temps de réticulation sous UV.

La courbe To correspond aux barreaux sans goutte de LP655, le courant ne passe pas. T1, correspondant à un temps de réticulation de 60 s, correspond au courant circulant entre les conducteurs avec une goutte de LP 655 non réticulé et donc relativement conducteur. Les courbes T2 à T5 correspondent, dans cet ordre à des états de plus en plus réticulés (temps de réticulation sous UV de plus en plus grands) et de moins en moins conducteurs. On constate que la conductivité électrique pour le temps de réticulation le plus long T5 est pratiquement identique à la conductivité To, i.e. sans goutte. Le matériau de la couche 6 pour un temps de réticulation correspondant à T5 est donc complétement isolant.

La couche de polarisation 6 s'étend de sorte à être en contact avec toutes les électrodes individuelles, afin de mettre toutes les électrodes individuelles en court-circuit. La couche de polarisation 6 ne recouvre pas nécessairement entièrement les électrodes individuelles.

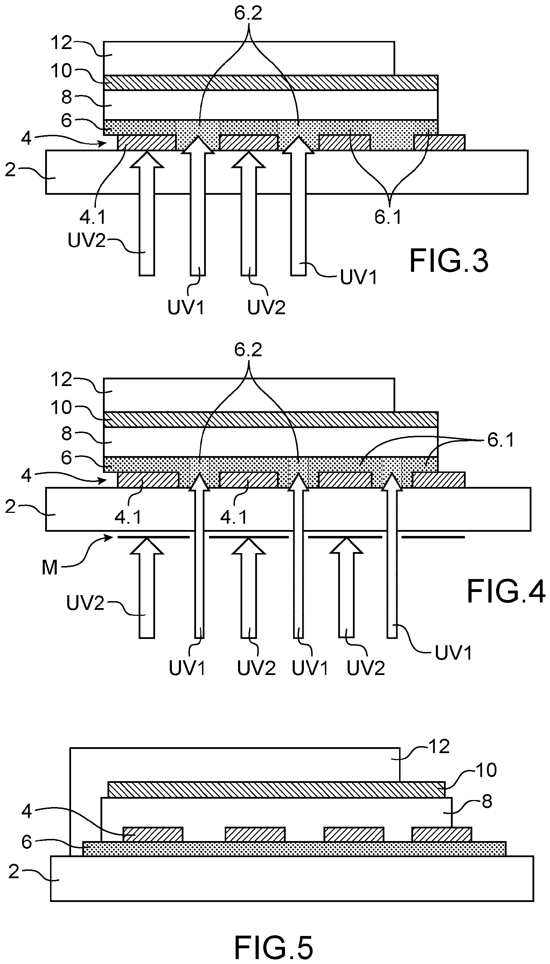

Sur la figure 5, on peut voir un empilement obtenu en mettant en œuvre un exemple de procédé de fabrication. Lors de la réalisation de l'empilement EP2, la couche de polarisation 6 est formée entre le substrat 2 et les électrodes individuelles.

La couche de polarisation 6 assure la connexion entre toutes les électrodes individuelles. La couche de PVDF est formée sur les électrodes individuelles. Du fait du procédé de fabrication, il se dépose également entre les électrodes individuelles et est en contact avec la couche de polarisation 6.

La couche de PVDF est ensuite rendue pyroélectrique. Pour cela, une tension de polarisation est appliquée entre l'électrode commune 10 et l'une des électrodes individuelles, voire entre l'électrode commune et la couche de polarisation, pour appliquer une tension suffisante afin de rendre le PVDF pyroélectrique. Par exemple, pour une couche de PVDF de 3 µm d'épaisseur, la tension de polarisation est de l'ordre de 300 V pendant quelques secondes.

Les zones de PVDF situées au droit des électrodes individuelles sont rendues pyroélectriques.

Cet exemple est particulièrement avantageux, car la réalisation de la couche de polarisation sur le substrat est très simple et ne demande pas de structuration de celle-ci.

En outre, la couche de polarisation 6 ainsi disposée ne forme pas de capacité supplémentaire entre les électrodes individuelles et l'électrode commune. De plus, lors du traitement, toute la couche de polarisation est rendue isolante électrique, par exemple en réalisant un traitement UV à travers le substrat choisi transparent aux UV.

Sur la figure 2, on peut voir un empilement obtenu en mettant en œuvre un procédé de fabrication selon un autre exemple.

Dans cet exemple, la couche de polarisation 6 est formée sur les électrodes individuelles 4.1. La couche de polarisation est telle qu'elle permet de connecter toutes les électrodes individuelles. Sur l'exemple de la figure 2, la couche de polarisation 6 ne recouvre que partiellement l'électrode individuelle située à l'extrémité droite dans la représentation de la figure 2, mais ce recouvrement partiel est suffisant pour la connecter aux autres électrodes individuelles.

La couche de PVDF est ensuite rendue pyroélectrique. Pour cela, une tension de polarisation est appliquée entre l'électrode commune 10 et l'une des électrodes individuelles, voire entre l'électrode commune et la couche de polarisation, pour appliquer une tension suffisante afin de rendre le PVDF pyroélectrique. Par exemple, pour une couche de de PVDF de 3 µm d'épaisseur, la tension de polarisation est de l'ordre de 300 V.

La mise en œuvre de la couche de polarisation permet simplement d'appliquer une tension de polarisation en une seule étape à toutes les zones de PVDF, en particuliers celles situées au droit des électrodes individuelles.

Lors d'une étape suivante et afin de rendre le dispositif fonctionnel, un traitement est appliqué à la couche de polarisation 6 afin de rendre celle-ci entièrement isolante électrique. Si la couche de polarisation est en colle époxy LP 655, celle-ci est réticulée par insolation UV à une longueur d'onde de l'ordre 365 nm. La durée de l'insolation est choisie pour s'assurer que la conductivité électrique de la colle soit suffisamment faible pour être considérée comme isolante, et que les électrodes individuelles ne soient plus électriquement connectées entre elles. La durée d'insolation est également suffisante pour que la colle assure la fonction d'adhésif et qu'elle soit suffisamment dure. Par exemple, la polarisation du PVDF est obtenue typiquement en appliquant un champ électrique de 100 volts pour une couche de PVDF de 1 µm. Dans le cas d'une couche de PVDF de 3 µm, un champ électrique d'environ 300 volts est appliqué.

Par exemple, l'insolation de la couche de polarisation se fait à travers le substrat qui est choisi transparent au rayonnement UV, par exemple celui-ci est en verre ou en matière plastique, et à travers les électrodes individuelles qui sont choisies suffisamment fines pour être transparentes au rayonnement UV.

En variante, l'insolation UV est réalisée à travers l'électrode commune lorsque le matériau de l'électrode commune est suffisamment transparent au rayonnement UV, ce qui est par exemple le cas d'une électrode commune organique, par exemple en PEDOT:PSS (mélange de poly(3,4-éthylènedioxythiophène) (PEDOT) et le poly(styrène sulfonate) de sodium (PSS)).

Après insolation toute la couche de polarisation 6 est rendue isolante.

La présence de la couche de polarisation 6 désormais isolante électrique ajoute une capacité en série, diminuant la capacité totale du pixel, ce qui ne perturbe pas sensiblement le fonctionnement du dispositif dans le cas d'une lecture en charge. Dans le cas d'une lecture en tension, sa présence peut être avantageuse car la tension produite est augmentée pour une même quantité de charge puisque la capacité totale du pixel est diminuée. La sensibilité de détection en est alors augmentée.

En outre la présence de cette couche isolante en contact avec le PVDF permet de réduire encore davantage le courant de fuite à travers le PVDF, qui est déjà faible du fait de la très bonne isolation électrique fournie par le PVDF.

Sur la figure 3, on peut voir un exemple de réalisation, dans lequel la couche de polarisation ne forme pas une capacité supplémentaire.

Pour cela, on choisit un substrat 2 suffisamment transparent au rayonnement UV, tel que le verre ou un matériau plastique, pour permettre une insolation à travers le substrat, comme cela est schématisé par les flèches UV, et on choisit des électrodes individuelles métalliques suffisamment épaisses pour ne pas être transparentes aux UV. Les rayons UV1 insolent la couche de polarisation 6, et les rayons UV2 sont stoppés par les électrodes 4.1. Il en résulte qu'à la fin de l'étape d'insolation, la couche de polarisation 6 conserve des zones conductrices 6.1 au droit des électrodes individuelles, séparées par des zones isolantes 6.2 entre les électrodes individuelles. Les zones conductrices 6.1 forment une prolongation des électrodes individuelles, dans la direction de l'épaisseur des électrodes.

Sur la figure 4, on peut voir une variante du procédé de la figure 3 dans laquelle lors de la phase de réticulation, un masque M est mis en œuvre pour masquer la couche de polarisation au rayonnement UV. Dans cet exemple, le masque M est disposé sous le substrat et est au droit de chaque électrode individuelle. En variante, le masque est disposé en dessus de l'électrode commune lorsque l'insolation se fait à travers l'électrode commune. Le masque est par exemple mis en œuvre lorsque les électrodes individuelles sont trop transparentes aux rayons UV pour empêcher la réticulation. Le masque est similaire à ceux communément utilisés dans les procédés microélectroniques. Les rayons UV1 insolent la couche de polarisation 6, et les rayons UV2 sont stoppés par le masque. Après traitement la couche de polarisation 6 comporte des portions isolantes électriques 6.2 qui isolent électriquement les électrodes individuelles 4.1.

Comme pour la figure 3, il en résulte une couche de polarisation alternant les zones conductrices électriques et les zones isolantes électriques.

Il sera compris que le traitement dépend du matériau de la couche de polarisation. Dans le cas d'une insolation, elle sera faite à une longueur d'onde apte à réticuler le matériau, qui peut être différente de celle d'un rayonnement UV.

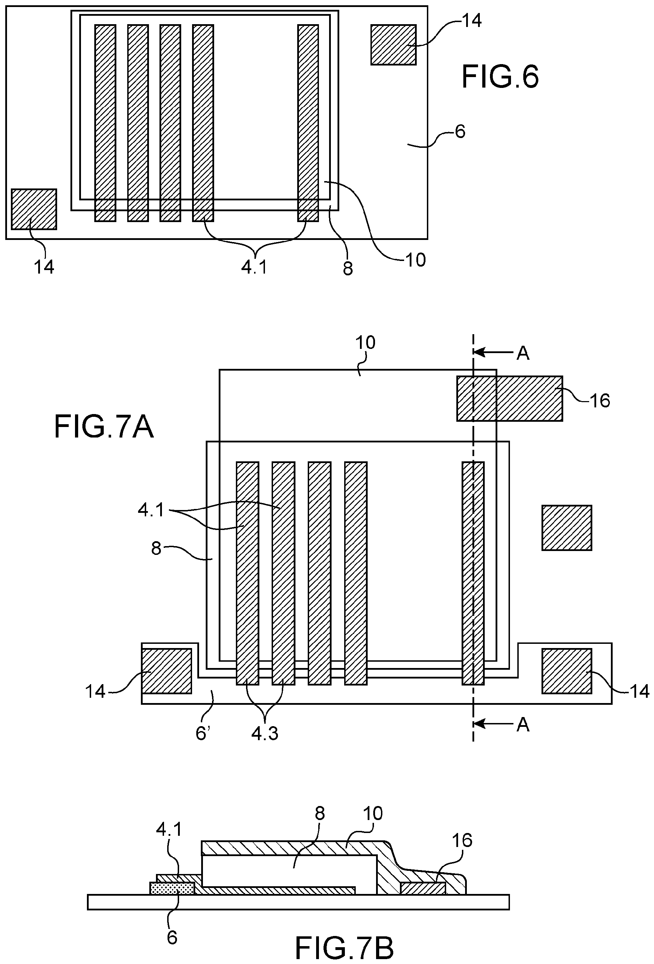

Sur la figure 6, on peut voir un empilement EP3 vu de dessus obtenu avec un procédé selon un autre exemple de réalisation, comportant des moyens permettant de vérifier que les électrodes individuelles sont effectivement isolées électriquement les unes des autres après le traitement de la couche de polarisation.

Sur la figure 6, deux plots de contact électriques 14 sont formés dans la couche de polarisation 6 en dehors de l'empilement avec la couche de PVDF, et de part et d'autre de l'empilement dans le plan de la couche de polarisation. Par exemple, en appliquant une tension entre les plots 14, on mesure un courant supérieur à un seuil donné si la couche de polarisation est conductrice électrique, et on mesure un courant inférieur au seuil donné si la couche de polarisation est isolante.

Les plots de contact 14 permettent également de mesurer la conduction de la couche de polarisation avant la polarisation du PVDF et de vérifier qu'elle est suffisamment conductrice, l'un des plots de contact peut être utilisé avec l'électrode commune, pour appliquer la tension de polarisation à la couche de PVDF.

Sur la figure 7A, on peut voir un autre exemple de réalisation dans lequel la couche de polarisation 6' est localisée, i.e. elle ne s'agit pas d'une couche pleine plaque. Dans l'exemple représenté, elle est formée au niveau des extrémités longitudinales 4.3 des électrodes individuelles.

La couche de polarisation est par exemple réalisée en utilisant un masque pour déposer de la colle de manière localisée, contrairement aux exemples de réalisation précédents dans lesquels la colle est déposée pleine plaque. Dans l'exemple représenté, la couche de polarisation est en forme de bande. En variante, la couche de polarisation peut avoir toute autre forme lui permettant d'être en contact avec toutes les électrodes individuelles 4.1.

Dans cet exemple, la couche de polarisation localisée est déposée entre le substrat et les électrodes individuelles comme pour l'exemple de la figure 5. Le reste de l'empilement accommode cette surépaisseur localisée. Cet exemple de réalisation réduit la quantité de matériau mise en œuvre pour réaliser la couche de polarisation.

Dans l'exemple représenté sur la figure 7A et de manière avantageuse, l'électrode commune 10 se prolonge par une reprise de contact 16 qui repose sur le substrat 2, et qui permet la connexion de l'électrode commune 10 à la masse ou à un potentiel fixe. La connexion, par exemple par une soudure, est facilitée, car la reprise de contact 16 repose sur un élément rigide, i.e. le substrat en verre ou autre matériau rigide, contrairement au PVDF.

Sur la figure 7B, on peut voir une vue en coupe de l'empilement de la figure 7A le long du plan A-A. on peut voir une extrémité de l'électrode 4.1 sur la couche de polarisation 6'. De manière avantageuse, la surface de la couche de PVDF est choisie de sorte à ce que la reprise contact 16 de l'électrode commune 10 soit à une distance suffisante de l'électrode individuelle 4.1, afin de réduire les risques de court-circuit entre l'électrode commune 10 et l'électrode individuelle 4.1. La mise en œuvre d'une couche de PVDF de grande surface permet également d'isoler les reprises de contact des lignes de chauffage éventuelles formées sur l'empilement.

En variante, la couche de polarisation est déposée entre les électrodes individuelles et la couche de PVDF.

Dans cet exemple, des plots de contact 14 sont réalisés aux deux extrémités de la couche de polarisation comme pour l'exemple de la figure 6, et permettent de vérifier la conductivité électrique de la couche de polarisation avant et/ou après le traitement.

En variante, on connecte la reprise de contact 16 et l'électrode commune 10 par une portion du même matériau que la couche de polarisation 6, afin de réaliser une connexion temporaire.

Dans le cas de l'empilement de la figure 7A, l'insolation de la couche de polarisation peut se faire directement par le dessus, ou par le dessous à travers le substrat. Ainsi au moins les zones de la couche de polarisation entre les électrodes individuelles sont rendues isolantes électriques et interrompent le court-circuit entre les électrodes.

Si les électrodes masquent la couche de polarisation aux UV, les zones de la couche de polarisation situées uniquement au droit des électrodes individuelles ne sont pas rendues isolantes, mais le fonctionnement du dispositif n'est pas perturbé.

De préférence, on choisit un substrat transparent aux rayons UV et on insole par la face arrière à travers le substrat ce qui permet d'insoler toute la bande de polarisation.

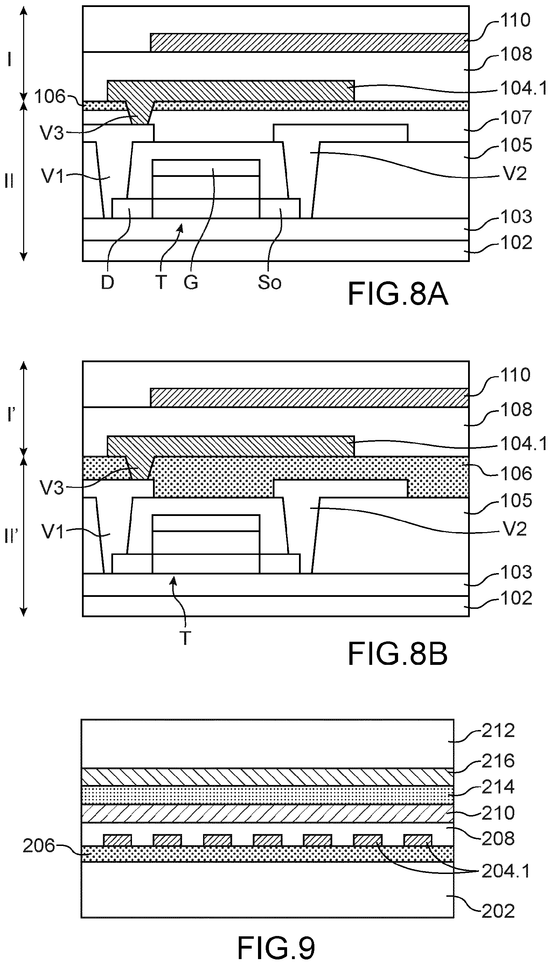

Sur les figures 8A et 8B, on peut voir des exemples de réalisation de capteurs d'empreinte ou plus généralement de capteurs de motifs thermiques comportant la partie de détection I et une partie électronique II mettant en œuvre des transistors.

La partie électronique comporte des transistors T, par exemple un transistor par pixel, chaque électrode individuelle étant alors connectée à un transistor.

Par exemple la partie électronique comporte un substrat support 102, par exemple en verre, une couche 103, par exemple en polyimide par exemple de 15 µm à 20 µm d'épaisseur, des transistors T, par exemple en couches minces ou TFT(thin films transistor en terminologie anglo-saxonne) réalisé par exemple en IGZO (Indium-Gallium-Zinc oxyde), une couche de SiN 105, et des vias V1 et V2 à travers la couche de SiN, reprenant le contact avec le drain D et la source So. La grille G comporte une connexion débouchant sur le bord du dispositif. Chaque drain D est connecté à une électrode inférieure 104.1 par un via V3.

Le dispositif comporte également une couche d'interface isolante 107 entre la partie électronique II et la partie de détection I, par exemple une couche polymère.

La couche de PVDF 108 est disposée entre l'électrode commune 110 et les électrodes individuelles 104.1.

Le dispositif comporte également une couche de polarisation 106 sur la couche d'interface et sous les électrodes individuelles et en contact avec celles-ci. Toutes les électrodes individuelles 104 sont reliées entre elles par la couche de polarisation 106. De plus les drains D sont connectées à la source de polarisation 106 par le via V3.

Les transistors sont répartis en lignes et en colonnes. Tous les transistors d'une colonne sont reliés par leur source So et tous les transistors d'une ligne sont reliés par leur grille, dite ligne de sélection.

Les colonnes de source et les lignes de grilles débouchent sur les côté de l'empilement. Avantageusement à l'aide de la couche de polarisation 106 ou d'une ou plusieurs autres couches de polarisation il est possible de connecter ensemble toutes les sources d'une part et toutes les grilles d'autre part. Lors de la polarisation du PVDF, les drains, les sources et les grilles sont à la terre.

Cet exemple de polarisation est particulièrement intéressant car la couche de polarisation permet d'atteindre les électrodes individuelles qui sont normalement enterrées dans l'empilement. Ainsi il est possible d'appliquer une polarisation au PVDF en appliquant une tension aux électrodes individuelles via la couche de polarisation qui est accessible sur un côté de l'empilement.

Sur la figure 8B, on peut voir un exemple particulièrement avantageux dans lequel la couche de polarisation 106 est interposée entre la partie électronique II et la partie détection I. La couche de polarisation 106 est en contact avec les vias V1, V2 et V3. Les électrodes individuelles 104.1, les sources So et les drains D sont alors en court-circuit via la couche 106. Comme pour l'exemple de la figure 8A, les lignes de grilles débouchent sur les côté de l'empilement. A l'aide de la couche de polarisation 106 ou d'une ou plusieurs autres couches de polarisation il est possible de connecter ensemble toutes les grilles et de les mettre à la terre. Lors de la polarisation du PVDF, les drains, les sources et les grilles sont à la terre.

Selon une variante avantageuse, on prévoit un via au niveau de la grille qui débouche dans la couche de polarisation, ce qui permet de mettre la grille, le drain et la source simultanément en court-circuit. Puisque toutes les grilles de chaque ligne de sélection sont reliées, il suffit d'un seul via entre une grille d'une ligne et la couche de polarisation. Le via est par exemple réalisé à l'extrémité d'une ligne.

Nous allons maintenant donner un exemple de réalisation pratique illustrant la faisabilité du procédé selon l'invention.

Nous considérons le capteur d'empreinte de la figure 9, il comporte un substrats 202, une couche de polarisation 206 directement sur le substrat 202 qui peut être recouvrir entièrement le substrat, comme représenté sur la figure 9, ou être localisée, des électrodes individuelles 204.1 par exemple en or de 50 nm d'épaisseur, une couche 208 de P(VDF-TrFE) par exemple entre 2 µm et 3 µm, une couche de conducteur pleine plaque 210 formant l'électrode commune, par exemple 0,3 µm de PEDOT:PSS, une couche diélectrique 214 par exemple en polyimide d'épaisseur de l'ordre de 0,2 µm, des lignes conductrices 216 orientées à angle droit par rapport aux électrodes individuelles 204.1, et formant les moyens de chauffage. Les lignes conductrices sont par exemple en argent de 1 µm d'épaisseur ou en or de 50 nm d'épaisseur, et une couche d'encapsulation 212.

Les électrodes individuelles et les lignes conductrices sont structurées finement au pas des pixels. Par exemple, on réalise une matrice de 128 × 128 pixels avec un pas de 90 µm. on réalise alors des électrodes individuelles ont une largeur de 60 µm espacées de 30 microns. Les pistes métalliques perpendiculaires aux électrodes sont au nombre de 128 et ont une largeur de 45 µm et sont espacés de 45 µm.

Nous allons déterminer la capacité de l'empilement électrode individuelles - PVDF - électrode commune.

La surface de la capacité est égale à :
128 colonnes x 60.10⁻⁶ x (128 x 90.10⁻⁶) = 88,4 10⁻⁶ m².

La couche de PVDF a une épaisseur de 3 µm.

La permittivité relative εᵣ du P(VDF-TrFE) est comprise entre 10 et 12.

La permittivité du vide ε₀ est de 8,85418782 × 10⁻¹² m⁻³ kg⁻¹s⁴A².

La capacité de l'empilement est alors égale à :
C = 8,85 × 10⁻¹² x 10 x 88.4 10⁻⁶ / 3 10⁻⁶ = 2,6 10⁻⁹ F =soit 2,6 nF.

Nous allons déterminer le temps nécessaire pour que le champ électrique s'établisse pour polariser le P(VD-TrFE), c'est-à-dire le temps de charge de la capacité à travers la résistance R d'accès.

Le P(VDF-TrFE) est considéré comme totalement isolant.

Quelques secondes de polarisation d'un champ électrique de l'ordre de 100 volts par micron suffisent pour rendre le P(VDF-TrFE) pyroélectrique.

Pour charger une capacité de 2,6 nF en une seconde, la constante de temps 1/RC nous indique que la résistance d'accès ne doit pas très supérieure à R = 380 MΩ.

Sous 300 volts, cela correspond à un courant momentané de 5.10⁻⁷ A à travers la résistance R.

Sur la figure 10, on voit que les courants circulant dans la couche de colle avant polymérisation (courbe T1) sont de l'ordre de 10⁻⁷ à 10⁻⁸ A avec une tension de quelques volts, par exemple à 5 volt, cela fait une résistance de 50 MΩ à 500 MΩ, ce qui est compatible avec la résistance d'accès: on pourra facilement adapter les temps.

Par conséquent la mise en œuvre d'une couche de polarisation telle que décrite permet effectivement de rendre le P(VDF-TrFE) pyroélectrique en un temps raisonnable.

Nous allons maintenant montrer que la polymérisation de la couche de polarisation est suffisante pour permettre le fonctionnement du capteur.

Par exemple pour les mesures, on connecte le dispositif à un convertisseur analogique Texas Instruments DDC264® (64 canaux, ADC 20 bit), sur une carte EVM du même nom à 256 entrées.

Le bruit mesuré est de l'ordre de 0,5 à 1 fC. Il sature à 12,5 pC dans le mode le plus sensible. On en déduit les ordres de grandeur suivants :
-on souhaite lire au minimum 6250 e⁻ = 6250 x 1,6.10⁻¹⁹ = 1 fC,
pour avoir 8 bits, on souhaite lire : 1600000 e⁻ = 256 fC (8 bit : 256 fois le minimum),
on ne souhaite pas dépasser 78 000 000 e⁻ = 12,5 pC pour éviter la saturation du dispositif.

Le coefficient pyroélectrique du P(VDF-TrFE) est de l'ordre de
29.10⁻⁶ C/m²/K

On souhaite mesurer la différence de température entre un pixel en contact avec de la peau et un pixel en contact avec de l'air.

Il a été estimé que la quantité de charges à générer pour avoir un résultat utilisable est d'environ 200 fC.

Les temps de lecture sont de l'ordre d'une milliseconde, i.e. le temps pour que le signal thermique se propage vers le P(VDF-TrFE).

Le courant moyen circulant dans une électrode colonne pour arriver jusqu'à l'électronique de lecture est de l'ordre de 200×10⁻¹⁵/10⁻³ = 2×10⁻¹⁰ A (0,2 nA).

On souhaite une isolation électrique d'au moins un facteur 100, soit un courant inférieur à 2×10⁻¹² A. Sur la figure 10, on peut voir que c'est l'ordre de grandeur du courant circulant dans la colle polymérisée.

La colle polymérisée est donc suffisamment isolante pour assurer le fonctionnement du dispositif.

Il sera compris que les électrodes individuelles peuvent avoir toutes formes.

Il sera compris que les différents exemples de réalisation peuvent être combinés. Par exemple, la couche de polarisation sur les électrodes individuelles par rapport au substrat peut être réalisée uniquement sur les extrémités longitudinales des électrodes en colonne.

Le fait de disposer l'électrode commune sur le matériau pyroélectrique présente l'avantage de blinder le dispositif contre les parasites électriques venant du doigt, dans une application à un capteur d'empreinte.

Par ailleurs, dans tous les exemples l'électrode commune est sur le matériau pyroélectrique par rapport au substrat. Selon d'autres exemples, elle se situe sous le matériau pyroélectrique du côté du substrat, et les électrodes individuelles sont sur le matériau pyroélectrique.

De plus, on peut envisager que l'électrode commune comporte autant d'électrodes que d'électrodes individuelles, lesdites électrodes étant reliées à une tension fixe.

Il sera compris que l'invention peut être appliquée à un empilement dans lequel plusieurs couches de polarisation sont mises en œuvre.

Le procédé de fabrication peut être mis en œuvre pour fabriquer des capteurs de motifs thermiques, par exemple des capteurs d'empreinte digitale, des caméras mettant en œuvre du PVDF.

La présente invention s'applique à d'autres matériaux qui sont capables d'acquérir une propriété électrique après avoir été soumis à une polarisation. Par exemple, l'invention s'applique aux matériaux capables de devenir piézoélectriques sous l'application d'une tension : le PVDF et le PZT deviennent également piézoélectriques lorsqu'ils sont soumis à une tension de polarisation.

L'invention s'applique également aux électrets. Un électret est un matériau diélectrique qui reste électrisé d'une façon permanente après avoir été soumis à un champ électrique temporaire. De tel matériau sont par exemple formés par des polymères, par exemple de la famille des VHB®, avantageusement du VHB4910®.

Des dispositifs piézoélectriques ainsi réalisés peuvent être utilisés comme capteur d'empreinte « à pression » ou à ultrasons, le matériau piézoélectrique est alors utilisé comme émetteur ultrasonique, le même matériau piézoélectrique peut être utilisé comme récepteur ou non.

Des dispositifs piézoélectriques ainsi réalisés peuvent également être utilisés comme actionneurs.

## Revendications

1. Procédé de fabrication d'un dispositif comportant un empilement comprenant une première couche (4) comportant au moins deux conducteurs électriques (4.1) isolés électriquement l'un de l'autre, une deuxième couche (10) comportant au moins un conducteur électrique, au moins une troisième couche (8) de matériau présentant au moins une propriété électrique, ladite troisième couche (8) étant disposée entre la première couche (4) et la deuxième couche (10), ledit procédé comportant :
a) une étape de réalisation, sur un substrat, d'un empilement comprenant la première couche (4), la deuxième couche (10) et la troisième couche (8) d'un matériau qui, après polarisation électrique, devient ledit matériau présentant ladite propriété électrique, la première couche (4) et la deuxième couche (10) étant disposées l'une par rapport à l'autre de sorte à permettre l'application d'une tension de polarisation au sein de la troisième couche (8),
b) une étape de réalisation d'une couche de polarisation (6) en contact électrique avec les au moins deux conducteurs électriques (4.1) de la première couche (4), ladite couche de polarisation (6) comportant un matériau qui présente un premier état dans lequel il est conducteur électrique et un deuxième état dans lequel il est isolant électrique, le passage du premier état au deuxième état étant obtenu par application d'un traitement à ladite couche de polarisation (6), ladite couche de polarisation (6) étant réalisée de sorte à être initialement dans son premier état,
c) une étape d'application d'une tension de polarisation à ladite troisième couche (8) de sorte que son matériau présente ladite propriété électrique,
d) une étape d'application dudit traitement transformant au moins une partie du matériau de la couche de polarisation (6) dans son deuxième état, de sorte que lesdits au moins deux conducteurs électriques (4.1) de la première couche (4) sont isolés électriquement les uns des autres.

2. Procédé de fabrication selon la revendication 1, dans lequel le matériau de la troisième couche (8) devient pyroélectrique en appliquant une polarisation donnée.

3. Procédé de fabrication selon la revendication 1 ou 2, dans lequel la couche de polarisation (6) est formée entre la première couche (4) et la troisième couche (8), ou dans lequel la couche de polarisation (6) est formée entre le substrat (2) et la première couche (4).

4. Procédé de fabrication selon l'une des revendications 1 à 3, dans lequel les conducteurs (4.1) de la première couche (4) sont réalisés en forme de bandes et dans lequel la couche de polarisation (6) est formée de sorte à être en contact avec une partie au moins de chacune des bandes.

5. Procédé de fabrication selon la revendication 4, dans lequel la couche de polarisation (6) est formée de sorte à être en contact avec une extrémité longitudinale des bandes.

6. Procédé de fabrication selon l'une des revendications 1 à 5, comportant l'étape de réalisation de deux contacts électriques (14) en contact électrique avec la couche de polarisation (6), lesdits contacts électriques (14) étant destinés à au moins vérifier la conductivité électrique de ladite couche de polarisation (6) au moins après le traitement.

7. Procédé de fabrication selon l'une des revendications précédentes, comportant l'étape de réalisation d'au moins deux transistors (T), chaque transistor étant connecté à un conducteur électrique (14), la couche de polarisation étant formée de sorte à être connectée électriquement au moins aux drains des transistors (T), dans lequel lors de l'étape c) la couche de polarisation, les drains, les sources et les grilles sont en court-circuit.

8. Procédé de fabrication selon l'une des revendications précédentes, dans lequel la couche de polarisation (6) est une colle réticulable contenant un ou plusieurs sels d'initiation de réticulation, et le traitement est une insolation au rayonnement ultraviolet.

9. Procédé de fabrication selon la revendication précédente, dans lequel le substrat (2) est en un matériau transparent au rayonnement ultraviolet et dans lequel l'insolation est réalisée à travers le substrat.

10. Procédé de fabrication selon la revendication 8 ou 9, dans lequel, lors de l'étape d), seules des portions de la couche de polarisation (6) situées entre les conducteurs (4.1) sont rendues isolantes électriques.

11. Procédé de fabrication selon l'une des revendications précédentes, dans lequel l'insolation se fait à travers un masque (M).

12. Procédé de fabrication selon l'une des revendications précédentes, dans lequel le matériau de la troisième couche (8) comporte du poly(fluorure de vinylidène) ou l'un de ses dérivés.

13. Procédé de fabrication d'un capteur de motifs thermiques comportant la fabrication d'un dispositif comprenant un empilement par le procédé selon l'une des revendications précédentes, l'étape de réalisation, sur ledit empilement, des lignes conductrices électriques formant une source de chaleur et l'étape de réalisation d'une couche d'encapsulation.

14. Empilement en vue de réaliser un dispositif comportant au moins une première couche (4) comportant au moins deux conducteurs électriques (4.1) isolés électriquement l'un de l'autre, une deuxième couche (10) comportant au moins un conducteur électrique, une troisième couche (8) en un matériau présentant après polarisation électrique au moins une propriété électrique, ladite troisième couche (8) étant disposée entre la première couche (4) et la deuxième couche (10), ledit empilement étant obtenu en mettant en œuvre le procédé de fabrication selon l'une des revendications 1 à 13, ledit empilement comportant la première couche (4), la deuxième couche (10), la troisième couche (8), le matériau de la troisième couche (8) ne présentant pas ladite propriété électrique et une couche de polarisation (6) en un matériau qui présente un premier état dans lequel il est conducteur électrique et un deuxième état dans lequel il est isolant électrique, le passage du premier état au deuxième état étant obtenu par application d'un traitement audit deuxième matériau, ladite couche de polarisation (6) étant réalisée de sorte à être initialement dans son premier état, ladite couche de polarisation (6) étant en contact électrique avec les conducteurs électriques (4.1) de la première couche (4).

15. Empilement selon la revendication précédente, dans lequel le matériau de la troisième couche (8) est du poly(fluorure de vinylidène) ou l'un de ses dérivés, et le matériau de la couche de polarisation (6) est une colle réticulable contenant un ou plusieurs sels d'initiation de réticulation, par exemple une colle époxy, ledit traitement étant une insolation au rayonnement ultra-violet.

## Patentansprüche

1. Verfahren zur Herstellung einer Vorrichtung, umfassend einen Stapel, der eine erste Schicht (4) mit wenigstens zwei elektrisch voneinander isolierten elektrischen Leitern (4.1), eine zweite Schicht (10) mit wenigstens einem elektrischen Leiter, wenigstens eine dritte Schicht (8) aus einem Material mit wenigstens einer elektrischen Eigenschaft umfasst, wobei die dritte Schicht (8) zwischen der ersten Schicht (4) und der zweiten Schicht (10) angeordnet wird, wobei das Verfahren umfasst:
a) einen Schritt der Herstellung eines Stapels auf einem Substrat, der die erste Schicht (4), die zweite Schicht (10) und die dritte Schicht (8) aus einem Material umfasst, das nach elektrischer Polarisierung zu dem Material wird, welches die elektrische Eigenschaft aufweist, wobei die erste Schicht (4) und die zweite Schicht (10) relativ zueinander derart angeordnet werden, dass sie das Anlegen einer Polarisationsspannung innerhalb der dritten Schicht (8) ermöglichen,
b) einen Schritt der Herstellung einer Polarisationsschicht (6) in elektrischem Kontakt mit den wenigstens zwei elektrischen Leitern (4. 1) der ersten Schicht (4), wobei die Polarisationsschicht (6) ein Material umfasst, das einen ersten Zustand aufweist, in dem es elektrisch leitend ist, und einen zweiten Zustand, in dem es elektrisch isolierend ist, wobei der Übergang von dem ersten Zustand zu dem zweiten Zustand durch Anwenden einer Behandlung auf die Polarisationsschicht (6) erreicht wird, wobei die Polarisationsschicht (6) derart hergestellt wird, dass sie anfänglich in ihrem ersten Zustand ist,
c) einen Schritt des Anwendens einer Polarisationsspannung auf die dritte Schicht (8), so dass ihr Material die elektrische Eigenschaft aufweist,
d) einen Schritt des Anwendens der Behandlung, die wenigstens einen Teil des Materials der Polarisationsschicht (6) in seinen zweiten Zustand umwandelt, derart, dass die wenigstens zwei elektrischen Leiter (4.1) der ersten Schicht (4) elektrisch voneinander isoliert werden.

2. Herstellungsverfahren nach Anspruch 1, wobei das Material der dritten Schicht (8) durch Anlegen einer bestimmten Vorspannung pyroelektrisch wird.

3. Herstellungsverfahren nach Anspruch 1 oder 2, wobei die Polarisationsschicht (6) zwischen der ersten Schicht (4) und der dritten Schicht (8) gebildet wird, oder wobei die Polarisationsschicht (6) zwischen dem Substrat (2) und der ersten Schicht (4) gebildet wird.

4. Herstellungsverfahren nach einem der Ansprüche 1 bis 3, wobei die Leiter (4.1) der ersten Schicht (4) in Form von Streifen hergestellt werden und wobei die Polarisationsschicht (6) derart gebildet wird, dass sie mit wenigstens einem Teil jedes der Streifen in Kontakt ist.

5. Herstellungsverfahren nach Anspruch 4, wobei die Polarisationsschicht (6) derart gebildet wird, dass sie ein Längsende der Streifen berührt.

6. Herstellungsverfahren nach einem der Ansprüche 1 bis 5, umfassend den Schritt des Herstellens von zwei elektrischen Kontakten (14) in elektrischem Kontakt mit der Polarisationsschicht (6), wobei die elektrischen Kontakte (14) dazu vorgesehen sind, die elektrische Leitfähigkeit der Polarisationsschicht (6) zumindest nach der Bearbeitung zu überprüfen.

7. Herstellungsverfahren nach einem der vorhergehenden Ansprüche, umfassend den Schritt der Herstellung von wenigstens zwei Transistoren (T), wobei jeder Transistor mit einem elektrischen Leiter (14) verbunden wird, wobei die Vorspannungsschicht derart gebildet wird, dass sie zumindest mit den Drains der Transistoren (T) elektrisch verbunden iwird, wobei in Schritt c) die Polarisationsschicht, die Drains, die Sources und die Gates kurzgeschlossen werden.

8. Herstellungsverfahren nach einem der vorhergehenden Ansprüche, wobei die Polarisationsschicht (6) ein vernetzbarer Klebstoff ist, der ein oder mehrere vernetzungsauslösende Salze enthält, und die Behandlung eine Bestrahlung mit Ultraviolettstrahlung ist.

9. Herstellungsverfahren nach dem vorhergehenden Anspruch, wobei das Substrat (2) aus einem für ultraviolette Strahlung durchlässigen Material besteht und wobei die Bestrahlung durch das Substrat hindurch durchgeführt wird.

10. Herstellungsverfahren nach Anspruch 8 oder 9, wobei in Schritt d) nur die zwischen den Leitern (4.1) befindlichen Teile der Polarisationsschicht (6) elektrisch isolierend gemacht werden.

11. Herstellungsverfahren nach einem der vorhergehenden Ansprüche, wobei die Belichtung durch eine Maske (M) erfolgt.

12. Herstellungsverfahren nach einem der vorhergehenden Ansprüche, wobei das Material der dritten Schicht (8) Polyvinylidenfluorid oder eines seiner Derivate umfasst.

13. Verfahren zur Herstellung eines Sensors für thermische Muster, umfassend die Herstellung einer Vorrichtung, die einen Stapel umfasst, durch das Verfahren nach einem der vorhergehenden Ansprüche, den Schritt der Herstellung von elektrisch leitenden Leitungen auf dem Stapel, die eine Wärmequelle bilden, und den Schritt der Herstellung einer Verkapselungsschicht.

14. Stapel zur Herstellung einer Vorrichtung mit wenigstens einer ersten Schicht (4), umfassend wenigstens zwei elektrische Leiter (4. 1), die voneinander elektrisch isoliert sind, eine zweite Schicht (10), die wenigstens einen elektrischen Leiter enthält, eine dritte Schicht (8) aus einem Material, das nach einer elektrischen Polarisation wenigstens eine elektrische Eigenschaft aufweist, wobei die dritte Schicht (8) zwischen der ersten Schicht (4) und der zweiten Schicht (10) angeordnet ist, wobei der Stapel durch Ausführen des Herstellungsverfahrens nach einem der Ansprüche 1 bis 13 erhalten wird, wobei der Stapel die erste Schicht (4), die zweite Schicht (10), die dritte Schicht (8) umfasst, wobei das Material der dritten Schicht (8) die genannte elektrische Eigenschaft nicht aufweist und eine Polarisationsschicht (6) aus einem Material, das einen ersten Zustand aufweist, in dem es elektrisch leitend ist, und einen zweiten Zustand, in dem es elektrisch isolierend ist, wobei der Übergang vom ersten Zustand in den zweiten Zustand durch Anwendung einer Behandlung auf das zweite Material erreicht wird, wobei die Polarisationsschicht (6) derart ausgeführt ist, dass sie anfänglich in ihrem ersten Zustand ist, wobei die Polarisationsschicht (6) in elektrischem Kontakt mit den elektrischen Leitern (4.1) der ersten Schicht (4) steht.

15. Stapel nach dem vorhergehenden Anspruch, wobei das Material der dritten Schicht (8) Polyvinylidenfluorid oder eines seiner Derivate ist und das Material der Polarisationsschicht (6) ein vernetzbarer Klebstoff ist, der ein oder mehrere vernetzungsauslösende Salze enthält, z.B. ein Epoxidklebstoff, wobei die Behandlung die Bestrahlung mit ultravioletter Strahlung ist.

## Claims

1. Manufacturing method for manufacturing a device comprising a stack including a first layer (4) omprising at least two electrical conductors (4.1) electrically insulated from each other, a second layer (10) comprising at least one electrical conductor, at least one third layer (8) of material with at least one electrical property, said third layer (8) being arranged between the first layer (4) and the second layer (10), said method comprising:
a) producing a stack on a substrate comprising the first layer (4), the second layer (10) and the third layer (8) of a material that, after electrical polarisation, becomes said material with said electrical property, the first layer (4) and the second layer (10) being arranged relative to each other so as to apply a polarisation voltage within the third layer (8),
b) producing a polarisation layer (6) in electrical contact with the at least two electrical conductors (4.1) of the first layer (4), said polarisation layer (6) comprising a material that has a first state in which it is electrically conducting and a second state in which it is electrically insulating, the change from the first state to the second state being obtained by application of a treatment to said polarisation layer (6), said polarisation layer (6) being made so that it is initially in its first state,
c) applying a polarisation voltage to said third layer (8) such that its material has said electrical property,
d) applying said treatment transforming at least part of the material of the polarisation layer (6) in its second state, such that said at least two electrical conductors (4.1) in the first layer (4) are electrically insulated from each other.

2. Manufacturing method according to claim 1, wherein the material of the third layer (8) becomes pyroelectric when a given polarisation is applied to it.

3. Manufacturing method according to claim 1 or 2, wherein the polarisation layer (6) is formed between the first layer (4) and the third layer (8), or wherein the polarisation layer (6) is formed between the substrate (2) and the first layer (4).

4. Manufacturing method according to one of the claims 1 to 3, wherein the conductors (4.1) in the first layer (4) are in the form of strips and wherein the polarisation layer (6) is formed so as to be in contact with at least part of each of the strips.

5. Manufacturing method according to claim 4, wherein the polarisation layer (6) is formed so as to be in contact with a longitudinal end of the strips.

6. Manufacturing method according to one of the claims 1 to 5, comprising a step to produce two electrical contacts (14) in electrical contact with the polarisation layer (6), said electrical contacts (14) being configured to at least verify the electrical conductivity of said polarisation layer (6) at least after the treatment.

7. Manufacturing method according to one of the preceding claims, comprising a step to produce at least two transistors (7), each transistor being connected to an electrical conductor (14), the polarisation layer being formed so as to be electrically connected at least to the transistor (T) drains, wherein during step c), the polarisation layer, the drains, the sources and the gates are short circuited.

8. Manufacturing method according to one of the preceding claims, wherein the polarisation layer (6) is a cross-linkable glue containing one or several cross-linking initiation salts and the treatment is ultraviolet radiation exposure.

9. Manufacturing method according to the preceding claim, wherein the substrate (2) is made of a material transparent to ultraviolet radiation and wherein the ultraviolet radiation exposure is made through the substrate.

10. Manufacturing method according to claim 8 or 9, wherein, during step d), only the portions of the polarisation layer (6) located between the conductors (4.1) are made electrically insulating.

11. Manufacturing method according to one of the preceding claims, wherein the exposure is made through a mask.

12. Manufacturing method according to one of the preceding claims, wherein the material of the third layer (8) comprises polyvinylidene fluoride or one of its derivatives.

13. Method of manufacturing a thermal patterns sensor including manufacturing of device comprising a stack using the method according to one of the preceding claims, a step to produce electrical conducting lines forming a heat source on said stack, and a step to produce an encapsulation layer.

14. Stack configured to be used in a device comprising at least one first layer (4) comprising at least two electrical conductors (4.1) electrically insulated from each other, a second layer (10) comprising at least one electrical conductor, a third layer (8) made of a material with at least one electrical property after electrical polarisation, said third layer (8) being located between the first layer (4) and the second layer (10), said stack being obtained using the manufacturing method according to one of the claims 1 to 13, said stack comprising the first layer (4), the second layer (10), the third layer (8), the material of the third layer (8) not having said electrical property and a polarisation layer (6) made of a material with a first state in which it is electrically conducting and a second state in which it is electrically insulating, the change from the first state to the second state being obtained by applying a treatment to said second material, said polarisation layer (6) being made so that it is initially in its first state, said polarisation layer (6) being in electrical contact with the electrical conductors (4.1) in the first layer (4).

15. Stack according to the preceding claim, wherein the material of the third layer (8) is polyvinylidene fluoride or one of its derivatives, and the material in the polarisation layer (6) is a cross-linkable glue containing one or several cross-linking initiation salts, for example an epoxy glue, said treatment being an ultraviolet radiation exposure.
